# EUROPEAN PATENT APPLICATION

(11) **EP 1 918 340 A2**
(43) Date of publication of application: **07.05.2008**
(21) Application number: 07254229.3
(22) Date of filing: 25.10.2007
(51) Int. Cl.: C09G 1/02, C09K 3/14

(54) **Polishing composition and polishing method**

(30) Priority: 31.10.2006 JP 2006296935
(71) Applicant: FUJIMI INCORPORATED, Aichi (JP)
(72) Inventor: Oh, Junhui, Kiyosu-shi Aichi (JP)
(74) Representative: Paget, Hugh Charles Edward

(57) **Abstract**

To provide a polishing composition suitable for use to polish a silicon dioxide film, particularly for use to polish a silicon dioxide film formed on a silicon substrate or a polysilicon film, and a polishing method by means of such a polishing composition.

The polishing composition of the present invention comprises a colloidal silica having a degree of association of more than 1, and an acid, and has a pH of from 1 to 4. The acid is preferably at least one member selected from the group consisting of a carboxylic acid and a sulfonic acid. This polishing composition preferably further contains an anionic surfactant. The anionic surfactant is preferably a sulfuric acid ester or a sulfonate.

## Description

The present invention relates to a polishing composition to be used for polishing a silicon dioxide film, particularly for polishing a silicon dioxide film formed on a silicon substrate or a polysilicon film, and a polishing method employing such a polishing composition.

As a semiconductor element isolation technique, a LOCOS (Local Oxidation of Silicon) technique is known wherein a silicon dioxide film for element isolation is selectively formed on a silicon substrate. However, this technique has a problem such that the element region decreases due to lateral diffusion of the silicon dioxide film and a bird's beak. Therefore, as a new semiconductor element isolation technique, a STI (Shallow Trench Isolation) technique has been developed and used.

According to the STI technique, usually, a silicon dioxide film and silicon nitride are formed in this order on a silicon substrate, and after patterning by a photoresist, a trench is formed. After removal of the resist, a silicon dioxide film is formed by SVD (Chemical Vapor Deposition), and planarization is carried out by CMP (Chemical Mechanical Polishing). And, after CMP, the silicon dioxide film remaining in the trench will function as an element isolation region. The silicon nitride film is removed after CMP, for example, by using a phosphoric acid solution. According to the STI technique, the silicon nitride film is formed as a stopper film, and the CMP slurry for STI is required to have a higher ability to polish the silicon dioxide film as compared with the silicon nitride film. Therefore, as a slurry of this type, one containing ceria abrasive grains is commonly employed (e.g. Patent Document 1). However, in order to obtain a practically sufficient stock removal rate of the silicon dioxide film, the average primary particle size of the ceria abrasive grains is required to be relatively large, and accordingly, there is a problem that many defects are likely to result on the surface after polishing by the slurry containing such ceria abrasive grains. Further, ceria abrasive grains are likely to remain as a residue on the surface after polishing, thus leading to a problem such that cleaning after polishing tends to be cumbersome.

On the other hand, to simplify the process of the STI technique, it has been proposed to omit forming of the silicon nitride film. In order to realize such a proposal, a CMP slurry is required whereby the stock removal rate of the silicon dioxide film is high, while the stock removal rate of a silicon substrate is low. Further, such a CMP slurry is desired to have a low stock removal rate of a polysilicon film formed, for example, at an element region. Namely, a CMP slurry is desired which is capable of selectively polishing a silicon dioxide film against a silicon substrate and a polysilicon film.
Patent Document 1: WO99/43761

It is an object of the present invention to provide a polishing composition suitable for use to polish a silicon dioxide film, particularly for use to polish a silicon dioxide film formed on a silicon substrate or a polysilicon film, and a polishing method employing such a polishing composition.

To accomplish the above object, the present invention provides the following:
1. A polishing composition comprising a colloidal silica having a degree of association of more than 1, and an acid, and having a pH of from 1 to 4.
2. The polishing composition according to the above 1, wherein the acid is at least one member selected from the group consisting of a carboxylic acid and a sulfonic acid.
3. The polishing composition according to the above 1 or 2, which further contains an anionic surfactant.
4. The polishing composition according to the above 3, wherein the anionic surfactant is a sulfuric acid ester or a sulfonate.
5. A polishing method which comprises polishing a silicon dioxide film by means of the polishing composition as defined in any one of the above 1 to 4.

Thus, the present invention presents a polishing composition suitable for use to polish a silicon dioxide film, particularly for use to polish a silicon dioxide film formed on a silicon substrate or a polysilicon film, and a polishing method employing such a polishing composition.

In the accompanying drawing:

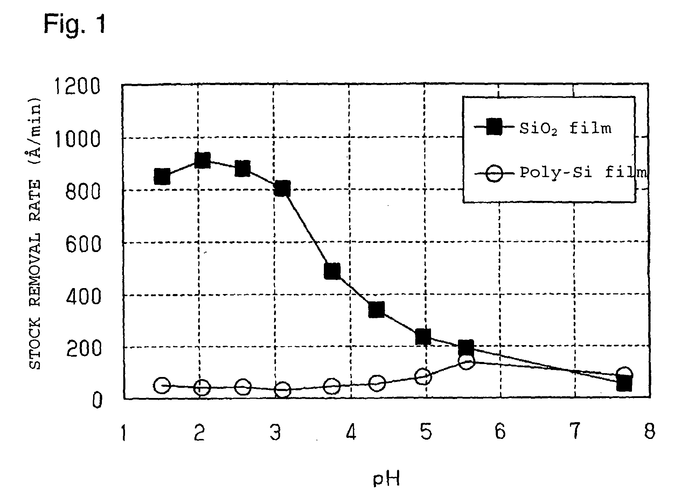

Fig. 1 is a graph showing the pH dependency of the stock removal rate of a silicon dioxide film and a polysilicon film by the polishing composition.

Now, the present invention will be described in further detail with reference to an embodiment of the present invention.

The polishing composition of this embodiment is prepared by mixing a colloidal silica and acid to water, so that the pH becomes from 1 to 4. Accordingly, the polishing composition comprises a colloidal silica, an acid and water. This polishing composition is used for an application to polish a silicon dioxide film, particularly for an application to polish a silicon dioxide film formed on a silicon substrate or a polysilicon film.

The above colloidal silica has a function to mechanically polish a silicon dioxide film and serves to improve the stock removal rate of the silicon dioxide film by the polishing composition. The colloidal silica may be prepared by various methods. However, one prepared by a sol-gel method is preferred, since inclusion of impurity elements is very little. The preparation of the colloidal silica by the sol-gel method is carried out usually by dropwise adding methyl silicate to a solvent comprising methanol, ammonia and water, followed by hydrolysis. However, in a case where presence of impurity elements is not so problematic, a colloidal silica by a so-called ion exchange method may be employed, wherein using sodium silicate as a starting material, the colloidal silica is formed by ion exchange.

The content of the colloidal silica in the polishing composition is preferably at least 1 mass%, more preferably at least 5 mass%. As the content of the colloidal silica increases, the stock removal rate of a silicon dioxide film by the polishing composition will be improved. In this respect, a practically particularly preferred polishing composition having a high stock removal rate of a silicon dioxide film can be obtained, when the content of the colloidal silica is at least 1 mass%, particularly preferably at least 5 mass%.

The content of the colloidal silica in the polishing composition is preferably at most 25 mass%, more preferably at most 20 mass%. As the content of the colloidal silica decreases, the dispersibility of the colloidal silica will be improved, and sedimentation in the polishing composition is less likely to occur. In this respect, it is possible to obtain a polishing composition wherein the dispersibility of the colloidal silica is practically particularly good, when the content of the colloidal silica is at most 25 mass%, more preferably at most 20 mass%.

The average primary particle size of the colloidal silica contained in the polishing composition is preferably at least 20 nm, more preferably at least 25 nm. As the average primary particle size of the colloidal silica increases, the function of the colloidal silica to mechanically polish a silicon dioxide film tends to increase, whereby the stock removal rate of the silicon dioxide film by the polishing composition will be improved. In this respect, it is possible to obtain a practically particularly suitable polishing composition having a high stock removal rate of a silicon dioxide film, when the average primary particle size of the colloidal silica is at least 20 nm, more preferably at least 25 nm.

The average primary particle size of the colloidal silica contained in the polishing composition is preferably at most 120 nm, more preferably at most 100 nm. As the average primary particle size of the colloidal silica decreases, the dispersibility of the colloidal silica will be improved, and sedimentation in the polishing composition tends to be less likely to occur. In this respect, it is possible to obtain a polishing composition wherein the dispersibility of the colloidal silica is practically particularly good, when the average primary particle size of the colloidal silica is at most 120 nm, more preferably at most 100 nm. Here, the value of the above average primary particle size is one calculated based on the specific surface area of the colloidal silica measured by BET method and the density of the colloidal silica particles.

It is essential that the degree of association of the colloidal silica contained in the polishing composition is more than 1. As the degree of association of the colloidal silica becomes large, the ability of the colloidal silica to mechanically polish a silicon dioxide film will be improved, whereby the stock removal rate of the silicon dioxide film by the polishing composition will be improved. In this respect, it is possible to obtain a practically particularly suitable polishing composition having a high stock removal rate of a silicon dioxide film, when the degree of the colloidal silica is more than 1. In order to further improve the stock removal rate of a silicon dioxide film by the polishing composition, the degree of association of the colloidal silica contained in the polishing composition is preferably at least 1.1, more preferably at least 1.5.

The degree of association of the colloidal silica contained in the polishing composition is preferably at most 5, more preferably at most 4. As the degree of association of the colloidal silica decreases, it is possible to reduce defects on the surface after polishing by the polishing composition. In this respect, it is possible to obtain a practically particularly suitable polished surface with little defects, when the degree of association of the colloidal silica is at most 5, more preferably at most 4. Here, the value of the above degree of association is one obtained by dividing the value of a secondary particle size being an average particle size of the colloidal silica obtained by a dynamic light-scattering method, by the value of a primary particle size of the colloidal silica.

The above-mentioned acid has a function to chemically polish a silicon dioxide film and serves to improve the stock removal rate of a silicon dioxide film by the polishing composition. Further, it serves to suppress polishing of a silicon substrate and a polysilicon film by the polishing composition.

The acid contained in the polishing composition may be an inorganic acid or an organic acid. However, a carboxylic acid or a sulfonic acid is preferred, since it has a particularly strong action to suppress polishing of a silicon substrate and a polysilicon film.

In a case where the acid contained in the polishing composition is a monocarboxylic acid represented by R-COOH or a dicarboxylic acid represented by HOOC-R-COOH, the carbon number in the R group is preferably at least 1, more preferably at least 2. As the carbon number in the R group increases, the function of the acid to suppress polishing of a silicon substrate and a polysilicon film tends to increase. In this respect, it is possible to obtain a practically particularly suitable polishing composition whereby the stock removal rate of the silicon substrate and the polysilicon film is low, when the carbon number in the R group is at least 1, more preferably at least 2. The carbon number in the R group is preferably at most 6, more preferably at most 4. As the carbon number of the R group decreases, the solubility of the acid in water will be improved. In this respect, it is possible to obtain a polishing composition wherein the solubility of the acid in water is practically particularly good, when the carbon number in the R group is at most 6, more preferably at most 4.

Specifically, the carboxylic acid may, for example, be formic acid, acetic acid, propionic acid, butyric acid, valeric acid, 2-methylbutyric acid, n-hexanoic acid, 3,3-dimethylbutyric acid, 2-ethylbutyric acid, 4-methylpentanoic acid, n-heptanoic acid, 2-methylhexanoic acid, n-octanoic acid, 2-ethylhexanoic acid, benzoic acid, glycolic acid (hydroxyacetic acid), salicylic acid, glyceric acid, oxalic acid, malonic acid, succinic acid, glutaric acid, adipic acid, suberic acid, pimelic acid, maleic acid, fumaric acid, malic acid, tartaric acid, citric acid, lactic acid, nicotinic acid, quinaldic acid or anthranilic acid. Further, it may be an aminocarboxylic acid such as α-alanine, β-alanine, glycine, aspartic acid, ethylenediamine-N,N,N',N'-tetraacetic acid, diethylenetriamine pentaacetic acid, 1,3-diaminopropane-N,N,N',N'-tetraacetic acid, 1,2-diaminopropane-N,N,N',N'-tetraacetic acid, ethylenediamine-N,N'-disuccinic acid (racemic form), ethylenediamine disuccinic acid (SS form), N-(2-carboxy-triethyl)-L-aspartic acid, N-(carboxymethyl)-L-aspartic acid, β-alanine diacetic acid, N-methyliminodiacetic acid, nitrilotriacetic acid, cyclohexanediamine tetraacetic acid, iminodiacetic acid, glycol ether diaminetetraacetic acid, ethylenediamine 1-N,N'-diacetic acid, ethylenediamine orthohydroxyphenylacetic acid or N,N-bis(2-hydroxybenzyl)ethylenediamine-N,N-diacetic acid. Among them, preferred is acetic acid, propionic acid, butyric acid, valeric acid, 2-methylbutyric acid, n-hexanoic acid, 3,3-dimethylbutyric acid, 2-ethylbutyric acid, 4-methylpentanoic acid, n-heptanoic acid, 2-methylhexanoic acid, n-octanoic acid, 2-ethylhexanoic acid, benzoic acid, glycolic acid, salicylic acid, glyceric acid, malonic acid, succinic acid, glutaric acid, adipic acid, suberic acid, pimelic acid, maleic acid, fumaric acid, malic acid, tartaric acid, citric acid, lactic acid, nicotinic acid, quinaldic acid or anthranilic acid, more preferred is acetic acid, propionic acid, n-hexanoic acid, glycolic acid, glyceric acid, malonic acid, succinic acid, glutaric acid, adipic acid, suberic acid, maleic acid, fumaric acid, malic acid, tartaric acid, citric acid or lactic acid, and most preferred is propionic acid, glycolic acid, malonic acid, succinic acid, glutaric acid, adipic acid or lactic acid, since the function to suppress polishing of a silicon substrate or a polysilicon film is particularly strong.

Further, the sulfonic acid may, for example, be sulfuric acid, an alkylsulfuric acid, an arylsulfuric acid, taurine, isethionic acid or benzenesulfonic acid. Among them, preferred is sulfuric acid, taurine, isethionic acid or benzenesulfonic acid, since the function to suppress polishing of a silicon substrate or a polysilicon film is particularly strong.

The content of the acid in the polishing composition is such an amount that the pH of the polishing composition becomes from 1 to 4, preferably from 1 to 3.5. When the pH of the polishing composition is acidic, it is possible to obtain a polishing composition having a high stock removal rate of a silicon dioxide film. Further, as the pH of the polishing composition changes from weakly acidic to strongly acidic, polishing of a silicon substrate or a polysilicon film by the polishing composition tends to be suppressed more strongly. In this respect, it is possible to obtain a practically particularly suitable polishing composition having a high stock removal rate of a silicon dioxide film and a low stock removal rate of a silicon substrate or a polysilicon film when the pH of the polishing composition is from 1 to 4, more preferably from 1 to 3.5.

According to this embodiment, the following merits can be obtained.

The polishing composition in this embodiment has a low stock removal rate of a silicon substrate or a polysilicon film while its stock removal rate of a silicon dioxide film is high. Accordingly, according to this polishing composition, it is possible to selectively polish a silicon dioxide film against a silicon substrate or a polysilicon film. Accordingly, this polishing composition is suitable for an application to polish a silicon dioxide film, particularly to polish a silicon dioxide film formed on a silicon substrate or a polysilicon film.

The above embodiment may be modified as follows.

To the polishing composition of the above embodiment, an anionic surfactant may be incorporated. The type of the anionic surfactant to be incorporated, is not particularly limited, but it is possible to use, for example, a dialkyl sulfosuccinate, an alkane sulfonate, an α-olefin sulfonate, an alkylbenzene sulfonate, a naphthalene sulfonate, an alkylnaphthalene sulfonate, an N-methyl-N-acyltaurine, an alkyl sulfate, a polyoxyethylene alkyl ether sulfate or a fat sulfuric acid ester. However, a sulfuric acid ester or a sulfonate is preferred, since its effect to suppress polishing of a silicon substrate or a polysilicon film is strong.

To the polishing composition of the above embodiment, at least two types of colloidal silica may be incorporated.

To the polishing composition, at least two types of acids may be incorporated. However, even in this case, the pH of the polishing composition must be from 1 to 4, preferably from 1 to 3.5.

To the polishing composition of the above embodiment, a chelating agent, a water-soluble polymer, a surfactant, an antiseptic, an antifungal agent or an anti-corrosion agent may, for example, be incorporated, as the case requires.

The polishing composition of the above embodiment may be used for an application to polish an object to be polished other than a silicon dioxide film.

The polishing composition of the above embodiment may be prepared by diluting a stock solution of the polishing composition with water.

Now, Examples and Comparative Examples of the present invention will be described.

### EXAMPLES 1 to 28 and COMPARATIVE EXAMPLES 1 to 18

Polishing compositions of Examples 1 to 28 and Comparative Examples 1 to 18 were prepared by optionally mixing abrasive grains and acids to water. The details of abrasive grains and acids in the polishing compositions and the pH of the polishing compositions are as shown in Tables 1 and 2.

In the column for "abrasive grains" in Tables 1 and 2, "colloidal silica^{*1}" represents a colloidal silica having an average primary particle size of 35 nm and a degree of association of 2.0, "colloidal silica^{*2}" represents a colloidal silica having an average primary particle size of 35 nm and a degree of association of 1.0, "colloidal silica^{*3}" represents a colloidal silica having an average primary particle size of 12 nm and a degree of association of 2.7, "colloidal silica^{*4}" represents a colloidal silica having an average primary particle size of 15 nm and a degree of association of 1.0, "colloidal silica^{*5}" represents a colloidal silica having an average primary particle size of 90 nm and a degree of association of 1.7, "fumed silica^{*1}" represents a fumed silica having an average primary particle size of 30 nm, "alumina^{*1}" represents an alumina having an average primary particle size of 5 µm, "alumina^{*2}" represents an alumina having an average primary particle size of 100 nm, and "ceria^{*1}" represents a ceria having an average primary particle size of 60 nm.

In the column for "stock removal rate" in Tables 1 and 2, the results of measurements of the stock removal rate of a silicon dioxide film (SiO₂ R.R.) and the stock removal rate of a polysilicon film (poly-Si R.R.) are shown when a silicon dioxide film (TEOS film)-coated substrate and a polysilicon film-coated substrate, each having a diameter of 200 mm, are polished under the conditions as identified in Table 3. The stock removal rate was obtained by dividing the difference in thickness of the substrate between before and after the polishing by the polishing time. For the measurement of the thickness of the substrate, an optical interferometric film thickness-measuring apparatus "RAMBDA ACE VM-2030" manufactured by DAINIPPON SCREEN MFG. CO., LTD. was used.

In the column for "selectivity" in Tables 1 and 2, the results of calculation of the ratio of the stock removal rate of the silicon dioxide film to the stock removal rate of the polysilicon film from the stock removal rates of the silicon dioxide film and the polysilicon film obtained as described above, are shown.

In the column for "surface defects" in Tables 1 and 2, the results of evaluation of surface defects on the silicon dioxide film-coated substrate polished under the conditions as shown in Table 3 by means of the polishing compositions of Examples 1 to 28 and Comparative Examples 1 to 18, are shown. Specifically, a silicon dioxide film-coated substrate polished by means of each polishing composition was washed for 12 seconds with a 0.5 mass% hydrofluoric acid solution, and then, by means of a wafer-inspection apparatus "SURFSCAN SP1-TB1" manufactured by KLA Tencor, the numbers of foreign matters and scratches having sizes of at least 0.2 µm present on the silicon dioxide film-coated substrate, were measured. In the column for "surface defects", ○ represents that the numbers of foreign matters and scratches having sizes of at least 0.2 µm were at least 1 and less than 25, Δ represents at least 25 and less than 50, and × represents at least 50.

In the column for "zeta potential" in Tables 1 and 2, the results of measurement of the zeta potential of abrasive grains in the polishing compositions of Examples 1 to 28 and Comparative Examples 1 to 18, are shown. For the measurement of the zeta potential, an ultrasonic particle size distribution-zeta potential measuring device "DT-1200" manufactured by Dispersion Technology, was used.

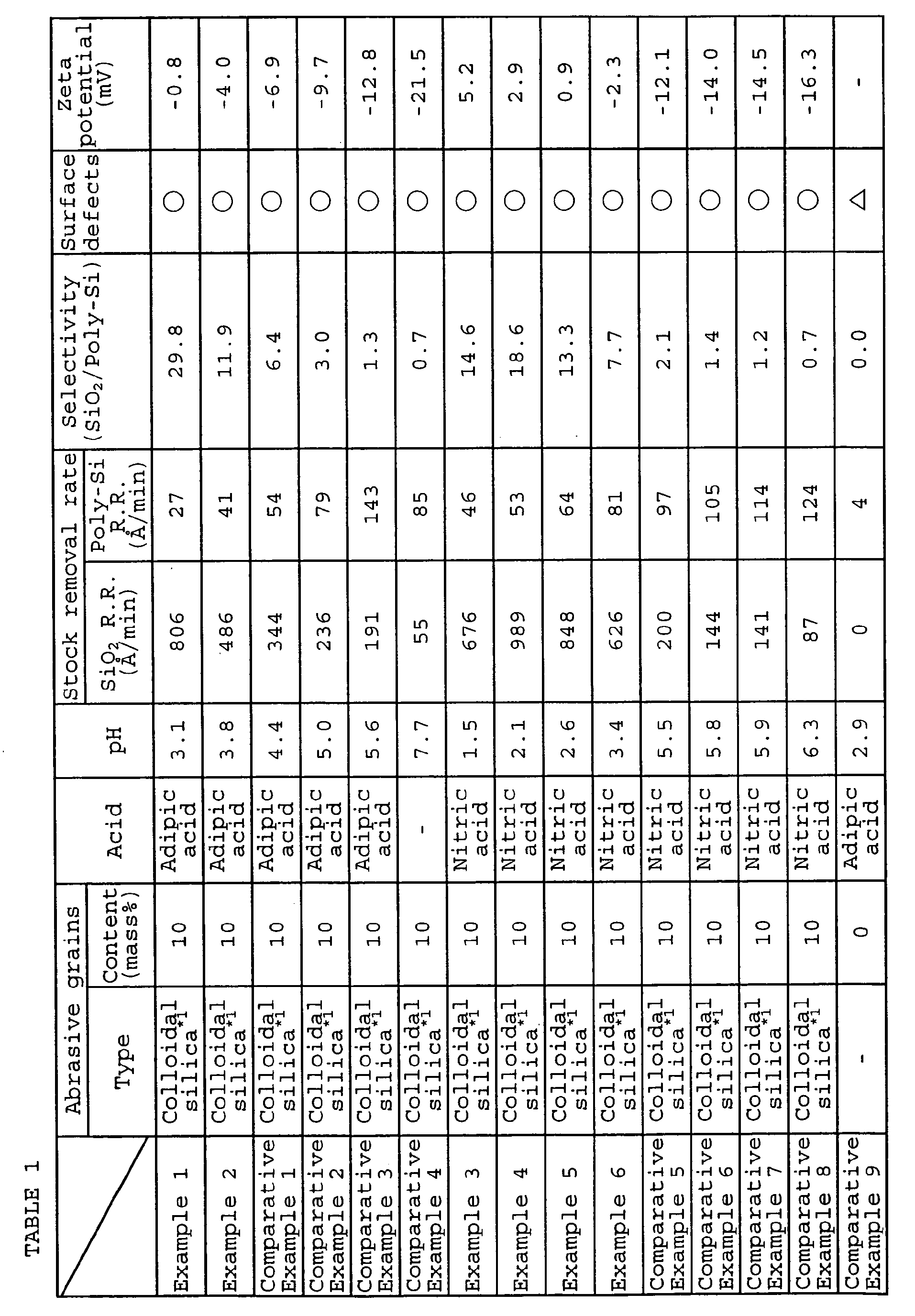

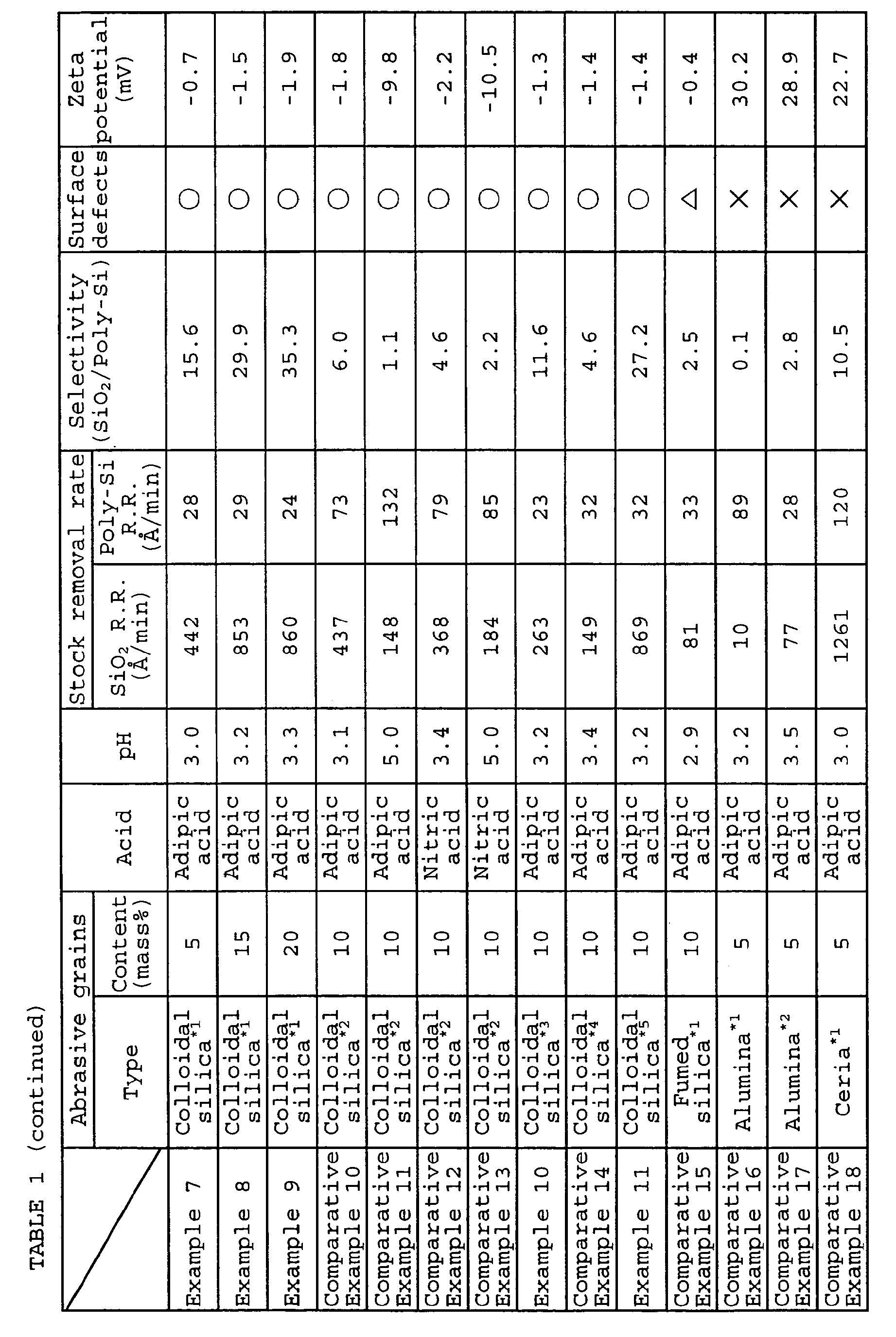

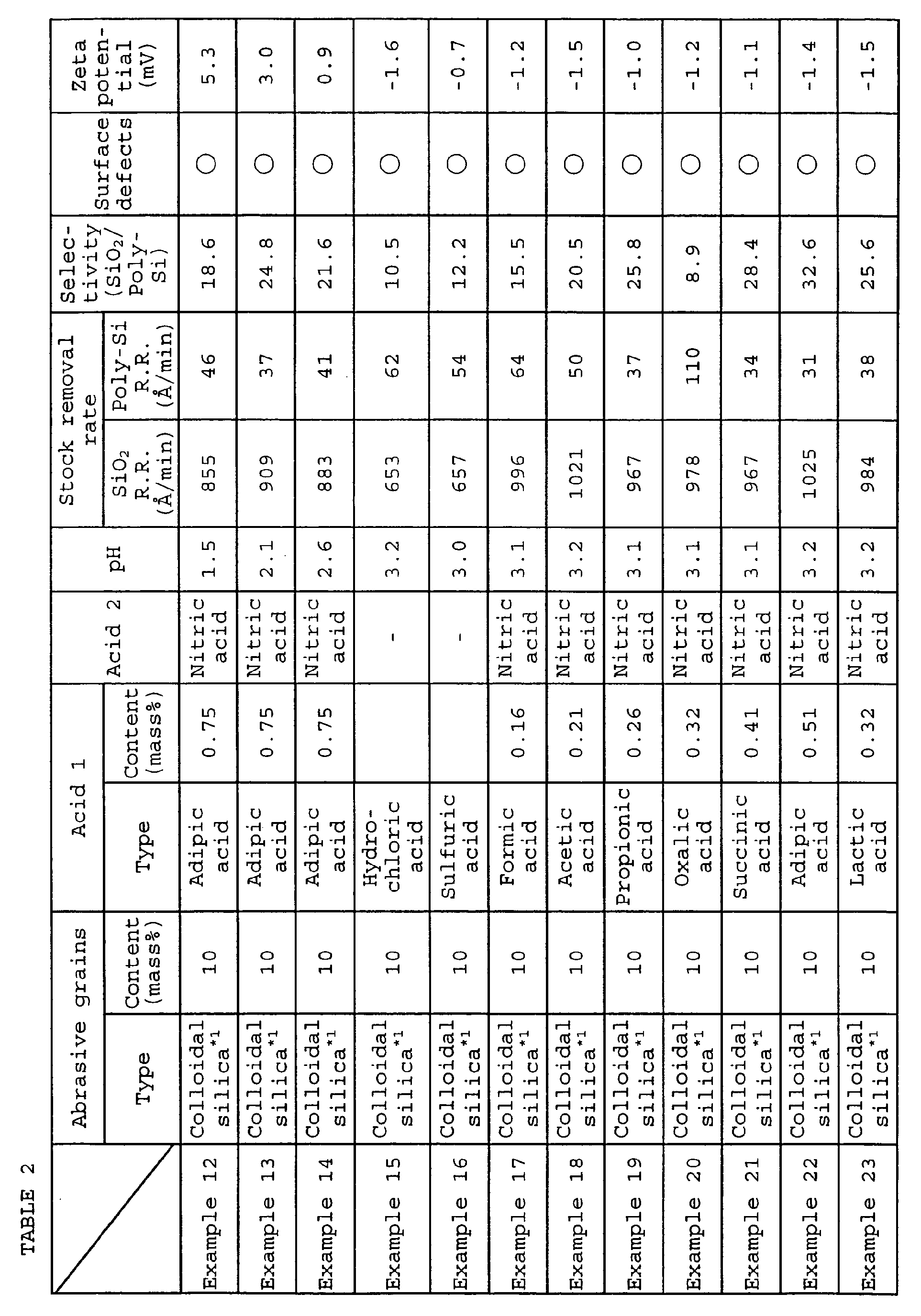

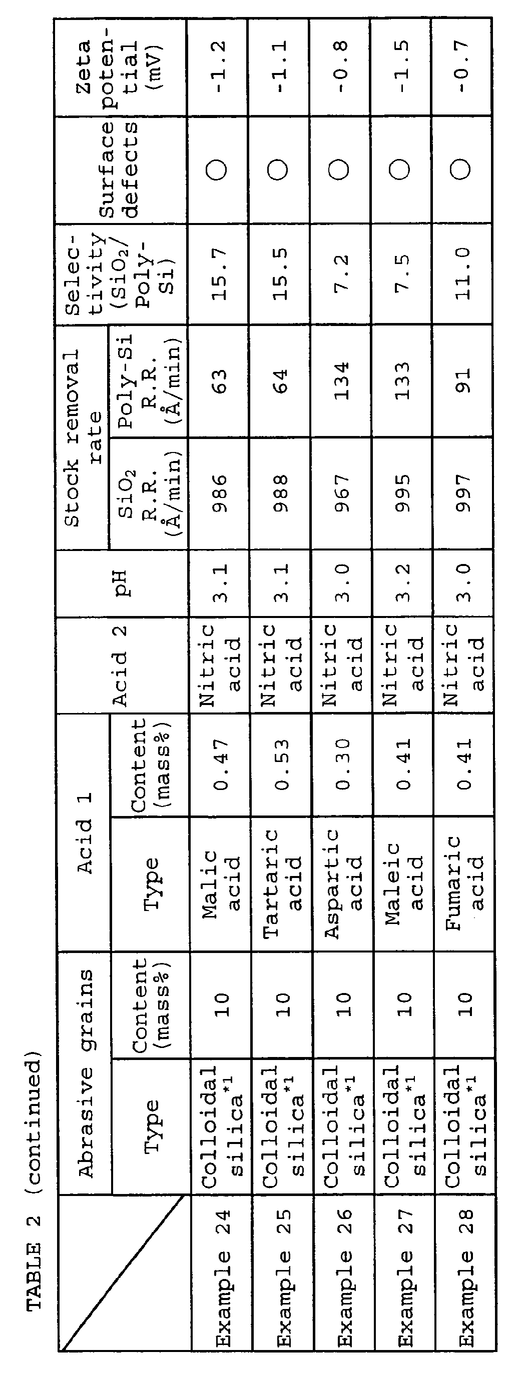

**TABLE 3**

| |
|---|
| Polishing machine: Mirra (manufactured by Applied Materials) |
| Polishing pad: IC-1010 M-Groove (manufactured Rohm and Haas Company) |
| Polishing pressure: 17.2 kPa (2.5 psi) |
| Plate rotational speed: 93 rpm |
| Carrier rotational speed: 87 rpm |
| Supply rate of polishing composition: 200 mL/min |
| Polishing time: 60 sec |

As shown in Tables 1 and 2, by the polishing compositions of Examples 1 to 28, with respect to the stock removal rate of the silicon dioxide film, numerical values of practically sufficient levels were obtained, and also with respect to the selectivity, numerical values of practically sufficient levels were obtained.

Whereas, by the polishing compositions of Comparative Examples 1 to 8 having a pH of at least 4, with respect to the stock removal rate of a silicon dioxide film, numerical values of practically sufficient levels were not obtained, and also with respect to the selectivity, numerical values of practically sufficient levels were not obtained. The results were the same also in the case of the polishing compositions of Comparative Examples 10 to 14 wherein a colloidal silica having a degree of association of 1.0 was used, or the polishing compositions of Comparative Examples 15 to 17 wherein fumed silica or alumina was used instead of the colloidal silica. Further, by the polishing composition of Comparative Example 18 wherein ceria was used instead of the colloidal silica, with respect to the stock removal rate of a silicon dioxide film, a numerical value of practically sufficient level was obtained, and also with respect to the selectivity, a numerical value of practically sufficient level was obtained, but scratches practically not permissible were observed on the polished surface.

Further, from the results of Examples 6 , 15 and 16, it was found that when sulfuric acid was used as an acid, polishing of a polysilicon film was strongly suppressed as compared with a case where nitric acid or hydrochloric acid was employed. Further, from the results of Examples 17 to 22, it was found that as the carbon number of the R group in the monocarboxylic acid or dicarboxylic acid used as an acid, increases, polishing of a polysilicon film tends to be strongly suppressed.

Further, a graph is shown in Fig. 1 wherein the numerical values of the stock removal rates of the silicon dioxide film and the polysilicon film by the polishing compositions of Examples 1, 2 and 12 to 14 and Comparative Examples 1 to 4 are plotted in a relation with the pH of the polishing compositions.

The entire disclosure of Japanese Patent Application No. 2006-296935 filed on October 31, 2006 including specification, claims, drawings and summary is incorporated herein by reference in its entirety.

## Claims

1. A polishing composition comprising a colloidal silica having a degree of association of more than 1, and an acid, and having a pH of from 1 to 4.

2. The polishing composition according to Claim 1, wherein the acid is at least one member selected from the group consisting of a carboxylic acid and a sulfonic acid.

3. The polishing composition according to Claim 1 or 2, which further contains an anionic surfactant.

4. The polishing composition according to Claim 3, wherein the anionic surfactant is a sulfuric acid ester or a sulfonate.

5. A polishing method which comprises polishing a silicon dioxide film by means of the polishing composition as defined in any one of Claims 1 to 4.
